(19) Europäisches Patentamt
European Patent Office
Office européen des brevets

(11) EP 4 039 767 A1

(12) EUROPEAN PATENT APPLICATION
published in accordance with Art. 153(4) EPC

(43) Date of publication:
**10.08.2022 Bulletin 2022/32**

(21) Application number: **20871043.4**

(22) Date of filing: **18.08.2020**

(51) International Patent Classification (IPC):
***C09K 3/14*** *(2006.01)* ***B24B 37/00*** *(2012.01)*
***H01L 21/304*** *(2006.01)*

(52) Cooperative Patent Classification (CPC):
**B24B 37/00; C09K 3/14; H01L 21/304**

(86) International application number:
**PCT/JP2020/031090**

(87) International publication number:
**WO 2021/065225 (08.04.2021 Gazette 2021/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2019 JP 2019179151**

(71) Applicant: **Fujimi Incorporated**
**Kiyosu-shi, Aichi 452-8502 (JP)**

(72) Inventors:
- **TANABE, Yoshiyuki**
  **Kiyosu-shi, Aichi 452-8502 (JP)**
- **TANIGUCHI, Megumi**
  **Kiyosu-shi, Aichi 452-8502 (JP)**

(74) Representative: **Grünecker Patent- und Rechtsanwälte**
**PartG mbB**
**Leopoldstraße 4**
**80802 München (DE)**

(54) **POLISHING COMPOSITION**

(57) The present invention provides means for improving flatness of an outer peripheral part of a silicon wafer while maintaining high polishing removal rate.

The present invention is a polishing composition used for polishing a silicon wafer, comprising an abrasive, a basic compound, a phosphorus-containing compound represented by chemical formula 1 below, and water:

[Formula 1]

(Chemical formula 1)

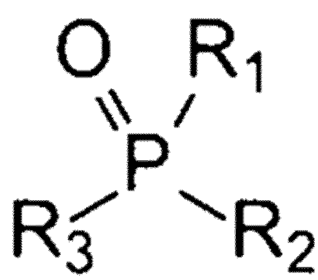

wherein, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

EP 4 039 767 A1

## Description

### TECHNICAL FIELD

The present invention relates to a polishing composition.

### BACKGROUND ART

Metals or semiconductors such as silicon, aluminum, nickel, tungsten, copper, tantalum, titanium and stainless steel, or alloys thereof; compound semiconductor wafer materials such as silicon carbide, gallium nitride, gallium arsenide, and the like are polished to fulfill various requirements such as flatness and are applied in various fields.

Among others, in order to produce mirror wafers having a high-quality mirror surface which is highly flat and free from scratches and impurities for producing semiconductor devices such as integrated circuits, various studies have been carried out on techniques for polishing single-crystalline silicon substrates (silicon wafers).

For example, Japanese Patent Laid-Open No. 2016-124943 proposed a polishing composition containing a polyvinyl alcohol based water-soluble polymer compound and a piperazine compound. Further, Japanese Patent Laid-Open No. 2016-124943 indicated that flatness of the peripheral part (outer peripheral part) of a silicon wafer after polishing is improved by the polishing composition.

While various other means for improving flatness of the outer peripheral part of silicon wafers has been proposed, development of new means is desired.

### SUMMARY OF INVENTION

Technical Problem

The present invention aims at providing means capable of improving flatness of an outer peripheral part of a silicon wafer while maintaining high polishing removal rate in polishing a silicon wafer.

Solution to Problem

The above-described problem is solved by a polishing composition used for polishing a silicon wafer, containing an abrasive, a basic compound, a phosphorus-containing compound represented by chemical formula 1 below, and water.

[Formula 1]

(Chemical formula 1)

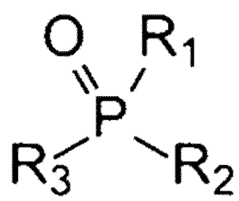

In the chemical formula 1, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

### DESCRIPTION OF EMBODIMENTS

Hereinafter, embodiments of the present invention will be described. However, the present invention is not limited only to the following embodiments. In addition, operation and measurement on physical properties and the like are measured under the conditions of room temperature (range of 20°C or more and 25°C or less)/relative humidity of 40% RH or more and 50% RH or less unless otherwise stated.

Hereinafter, details of a polishing composition of the present invention will be described.

[Polishing Composition]

One embodiment of the present invention is a polishing composition used for polishing a silicon wafer, containing an abrasive, a basic compound, a phosphorus-containing compound represented by chemical formula 1 below, and water.

[Formula 2]

(Chemical formula 1)

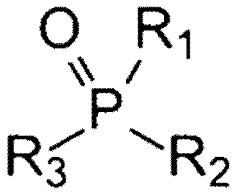

In the chemical formula 1, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

The present inventors have made intensive studies from the viewpoint of improving flatness of an outer peripheral part of a silicon wafer and improving polishing removal rate. As a result, the present inventors have found that flatness of an outer peripheral part of a silicon wafer can be improved while maintaining high polishing removal rate of the silicon wafer by a polishing composition containing the phosphorus-containing compound represented by the chemical formula 1.

Although the working mechanism by which the above-described effect is obtained with the polishing composition of the present invention is not clear, it is considered as follows. The phosphorus-containing compound according to the present invention is considered to function to protect the outer peripheral part of a silicon wafer and prevent the outer peripheral part from being excessively polished. It is considered that when a silicon wafer is polished with a polishing composition containing this phosphorus-containing compound, both improvement in flatness of the outer peripheral part of a silicon wafer and good polishing removal rate can be achieved.

The above-described mechanism is based on speculation, and whether it is correct or not does not affect the technical scope of the present application.

[Object to be polished]

The polishing composition according to the present invention is used for application in which a silicon wafer is polished. Here, the silicon wafer may be one made from elemental silicon such as a single-crystalline silicon substrate and a polycrystalline silicon substrate or may be one composed of a layer formed from elemental silicon and another layer. In addition, it is acceptable that the silicon wafer contains an element other than silicon in a content to the extent of impurities. Therefore, the silicon wafer may contain a p-type dopant such as boron and an n-type dopant such as phosphorus. A crystal orientation of the silicon wafer is also not particularly limited and may be any of <100>, <110>, and <111>. In addition, a resistivity of the silicon wafer is also not particularly limited. In addition, a thickness of the silicon wafer is 600 to 1000 μm, for example, but is not particularly limited. The composition of the present invention is also applicable to wafers with any diameter such as 200 mm, 300 mm, and 450 mm. Needless to say, other wafers with other diameters than these may be used.

Next, constituent components of the polishing composition of the present invention will be described.

[Abrasive]

The polishing composition of the present invention contains an abrasive. The abrasive contained in the polishing composition function to mechanically polish silicon wafers.

The abrasive used in the present invention can be used singly or in combination of two or more kinds. The abrasive may be any of inorganic particles, organic particles, and organic-inorganic composite particles. Specific examples of the inorganic particles include, for example, particles formed from a metal oxide such as silica, alumina, ceria, and titania, silicon nitride particles, silicon carbide particles, and boron nitride particles. Specific examples of the organic particles include, for example, polymethyl methacrylate (PMMA) particles. In addition, for the abrasive, commercially available products may be used, or synthetic products may be used. Unless otherwise specified herein, the abrasives

refer to those without surface modification.

Among these abrasives, silica is preferable, and colloidal silica is especially preferable.

A lower limit of an average primary particle diameter of the abrasive is preferably 10 nm or more, more preferably 15 nm or more, still more preferably 20 nm or more, further preferably 30 nm or more, even more preferably 40 nm or more, and especially preferably 50 nm or more. In such a range, high polishing removal rate can be maintained, and the abrasive is thus suitably used in a rough polishing step. In addition, an upper limit of the average primary particle diameter of the abrasive is preferably 200 nm or less, more preferably 150 nm or less, and still more preferably 100 nm or less. In several aspects, the average primary particle diameter may be 75 nm or less, or may be 60 nm or less. In such a range, occurrence of defects on the surface of a silicon wafer after polishing can be further suppressed. The average primary particle diameter of the abrasive is calculated on the basis of a specific surface area of the abrasive measured by a BET method, for example.

A lower limit of an average secondary particle diameter of the abrasive is preferably 15 nm or more, more preferably 30 nm or more, still more preferably 40 nm or more, even more preferably 50 nm or more, and especially preferably 60 nm or more (for example, 80 nm or more). In such a range, high polishing removal rate can be maintained. In addition, an upper limit of the average secondary particle diameter of the abrasive is preferably 300 nm or less, more preferably 260 nm or less, still more preferably 220 nm or less, and especially preferably 150 nm or less (for example, 130 nm or less). In such a range, occurrence of defects on the surface of a silicon wafer after polishing can be further suppressed. The average secondary particle diameter of the abrasive can be measured by a dynamic light scattering method, for example.

An average association degree of the abrasive is preferably 1.2 or more, more preferably 1.4 or more, and still more preferably 1.5 or more. The average association degree herein is obtained by dividing the value of the average secondary particle diameter of the abrasive by the average primary particle diameter. When the average association degree of the abrasive is 1.2 or more, an advantageous effect of improving polishing removal rate is provided, which is preferable. In addition, the average association degree of the abrasive is preferably 4 or less, more preferably 3.5 or less, and still more preferably 3 or less. As the average association degree of the abrasive becomes smaller, a polished surface with less surface defects caused by polishing the object to be polished using the polishing composition, is easily obtained.

When the polishing composition is directly used as a polishing slurry, a content of the abrasive is preferably 0.1% by mass or more, more preferably 0.5% by mass or more, and still more preferably 1.0% by mass or more based on the polishing composition. Polishing removal rate is improved by increase of the content of the abrasive. In addition, when the polishing composition is directly used as a polishing slurry, from the viewpoint of preventing scratches, etc., the content of the abrasive is usually suitable to be 10% by mass or less and is preferably 5% by mass or less, more preferably 3% by mass or less, and still more preferably 2% by mass or less. Reducing the content of the abrasive is also preferable from the viewpoint of economic efficiency.

In addition, when the polishing composition is diluted and used for polishing, that is, when the polishing composition is a concentrate, from the viewpoint of storage stability, filtration properties, etc., usually, the content of the abrasive is preferably 50% by mass or less and more preferably 40% by mass or less based on the polishing composition. In addition, from the viewpoint of taking advantage of making the polishing composition into a concentrated liquid, the content of the abrasive is preferably 1% by mass or more and more preferably 5% by mass or more.

When two or more kinds of the abrasive are used in combination, the above-described content refers to a total content of two or more kinds of the abrasive.

[Phosphorus-containing compound]

The polishing composition according to the present invention contains a phosphorus-containing compound represented by chemical formula 1 below. It is considered that the phosphorus-containing compound functions to protect the outer peripheral part of a silicon wafer and prevent the outer peripheral part from being excessively polished. Therefore, it is considered that when a silicon wafer is polished with a polishing composition containing this phosphorus-containing compound, both improvement in flatness of an outer peripheral part of a silicon wafer and good polishing removal rate can be achieved.

[Formula 3]

(Chemical formula 1)

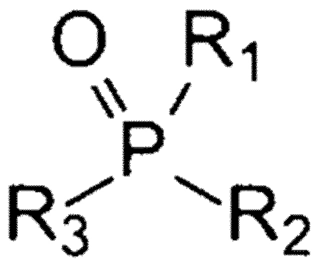

In the chemical formula 1, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

Examples of the unsubstituted straight chain or branched alkoxy group having 1 to 20 carbon atoms adopted as $R_1$, $R_2$, and $R_3$ include, for example, a methoxy group, an ethoxy group, a n-propyloxy group, an isopropyloxy group, a n-butyloxy group, an isobutyloxy group, a sec-butyloxy group, a tert-butyloxy group, a n-pentyloxy group, a n-hexyloxy group, a n-heptyloxy group, a n-octyloxy group, a 2-ethylhexyloxy group, a n-nonyloxy group, a n-decyloxy group, a n-undecyloxy group, a n-tridecyloxy group, a n-tetradecyloxy group, a n-pentadecyloxy group, a n-hexadecyloxy group, a n-heptadecyloxy group, a n-octadecyloxy group, a n-nonadecyloxy group, a n-eicosyloxy group, etc.

The phosphorus-containing compound used in the present invention can be used singly or in combination of two or more kinds. In addition, for the phosphorus-containing compound, commercially available products may be used, or synthetic products may be used. Specific examples of the phosphorus-containing compound represented by the chemical formula 1 include, for example, a phosphoric acid ester compound such as monomethyl phosphate, dimetnyl phosphate, trimethyl phosphate, monoethyl phosphate, diethyl phosphate, triethyl phosphate, monoisopropyl phosphate, diisopropyl phosphate, triisopropyl phosphate, monobutyl phosphate, dibutyl phosphate, tributyl phosphate, mono(2-ethylhexyl) phosphate, bis(2-ethylhexyl) phosphate, and tris(2-ethylhexyl) phosphate; a phosphorous acid ester compound such as monomethyl phosphite, dimethyl phosphite, monoethyl phosphite, diethyl phosphite, monoisopropyl phosphite, diisopropyl phosphite, monobutyl phosphite, and dibutyl phosphite; etc.

In the chemical formula 1, at least one of $R_1$, $R_2$, and $R_3$ is preferably an unsubstituted straight chain alkoxy group having 1 to 20 carbon atoms and is more preferably an unsubstituted straight chain alkoxy group having 1 to 10 carbon atoms. This is because both improvement in flatness of the outer peripheral part of a silicon wafer and good polishing removal rate can be achieved at a higher level.

In addition, it is preferable that the phosphorus-containing compound represented by the chemical formula 1 be a phosphoric acid ester compound. That is, it is preferable that $R_1$ and $R_2$ in the chemical formula 1 be each independently a hydroxy group or an unsubstituted straight chain or branched alkoxy group having 1 to 20 carbon atoms, more preferably 1 to 15 carbon atoms, still more preferably 1 to 10 carbon atoms, and may be 1 to 5 (for example, 1 to 3) carbon atoms. Such a range can be significant in improvement in flatness of the outer peripheral part of a silicon wafer and in dispersion stability of the polishing composition. Furthermore, among phosphoric acid ester compounds, a compound having more ester structures such as a phosphoric acid diester compound and a phosphoric acid triester compound is more preferable, for example. This is because these phosphorus-containing compounds can achieve both improvement in flatness of the outer peripheral part of a silicon wafer and good polishing removal rate at a higher level.

Among others, more preferable phosphorus-containing compounds include a phosphoric acid ester compound such as a phosphoric acid diester compound and a phosphoric acid triester compound; a phosphorous acid ester compound such as a phosphorous acid monoester and a phosphorous acid diester; etc., and triethyl phosphate is more preferable.

When the polishing composition contains two or more kinds of the phosphorus-containing compound represented by the chemical formula 1, the phosphorus-containing compound can be used in any of the following combinations, for example: two or more phosphoric acid monoester compounds; two or more phosphoric acid diester compounds; two or more phosphoric acid triester compounds; one or more phosphoric acid monoester compounds and one or more phosphoric acid diester compounds; one or more phosphoric acid monoester compounds and one or more phosphoric acid triester compounds; one or more phosphoric acid diester compounds and one or more phosphoric acid triester compounds; two or more phosphorous acid monoester compounds; two or more phosphorous acid diester compounds; two or more phosphorous acid triester compounds; one or more phosphorous acid monoester compounds and one or more phosphorous acid diester compounds; one or more phosphorous acid monoester compounds and one or more phosphorous acid triester compounds; and one or more phosphorous acid diester compounds and one or more phosphorous acid triester compounds. When a phosphoric acid monoester compound and a phosphoric acid diester compound are used in combination as the phosphorus-containing compound, specific examples thereof include the combination of monoisopropyl phosphate and diisopropyl phosphate.

When the polishing composition is directly used as a polishing slurry, a content of the above-described phosphorus-containing compound is preferably 0.0001% by mass or more, more preferably 0.0015% by mass or more, and still more preferably 0.002% by mass or more based on the polishing composition. In addition, when the polishing composition is directly used as a polishing slurry, the content of the above-described phosphorus-containing compound is preferably 0.01% by mass or less, more preferably 0.008% by mass or less, and still more preferably 0.006% by mass or less. This is because both improvement in flatness of the outer peripheral part of a silicon wafer and good polishing removal rate can be achieved at a higher level in such a content range.

In addition, when the polishing composition is diluted and used for polishing, that is, when the polishing composition is a concentrate, from the viewpoint of storage stability, etc., the content of the phosphorus-containing compound is preferably 0.5% by mass or less and more preferably 0.3% by mass or less based on the polishing composition. In addition, from the viewpoint of taking advantage of making the polishing composition into a concentrate, the content of the phosphorus-containing compound is preferably 0.01% by mass or more and more preferably 0.015% by mass or more.

When two or more kinds of the phosphorus-containing compound are used in combination, the above-described content refers to a total content of two or more kinds of the phosphorus-containing compound.

When the polishing composition contains two or more kinds of the phosphorus-containing compound represented by the chemical formula 1, the ratio between contents of the phosphorus-containing compound is not particularly limited. For example, when a phosphoric acid monoester compound and a phosphoric acid diester compound are used in combination, the above ratio of phosphoric acid monoester compound:phosphoric acid diester compound in terms of mass ratio may be 5:95 to 95:5 and may be 10:90 to 90:10. From the viewpoint of improvement in flatness, the above ratio may be 20:80 to 80:20, may be 25:75 to 75:25, and may be 25:75 to 45:55, for example.

[Basic compound]

The polishing composition according to the present invention contains a basic compound. The basic compound herein refers to a compound functioning to increase the pH of the composition by being added to the polishing composition. The basic compound functions to chemically polish the surface to be polished and can contribute to improvement in polishing removal rate. In addition, the basic compound can help in improving dispersion stability of the polishing composition.

The basic compound used in the present invention can be used singly or in combination of two or more kinds. The basic compound includes an organic or inorganic basic compound containing nitrogen, a hydroxide of an alkali metal or Group 2 metal, and various carbonates and hydrogen carbonates; a quaternary ammonium hydroxide or a salt thereof; and ammonia, amine, etc. Specific examples of the hydroxide of an alkali metal include potassium hydroxide, sodium hydroxide, etc. Specific examples of the carbonates or hydrogen carbonates include ammonium hydrogen carbonate, ammonium carbonate, potassium hydrogen carbonate, potassium carbonate, sodium hydrogen carbonate, sodium carbonate, etc. Specific examples of the quaternary ammonium hydroxide or salt thereof include tetramethylammonium hydroxide (TMAH), tetraethylammonium hydroxide, tetrabutylammonium hydroxide, etc. Specific examples of the amine include methylamine, dimethylamine, trimethylamine, ethylamine, diethylamine, triethylamine, ethylenediamine, monoethanolamine, N-(β-aminoethyl)ethanolamine, hexamethylenediamine, diethylenetriamine, triethylenetetramine, piperazine anhydride, piperazine hexahydrate, 1-(2-aminoethyl)piperazine, N-methylpiperazine, guanidine, azoles such as an imidazol and a triazol, etc.

From the viewpoint of improving polishing removal rate, etc., a preferable basic compound includes at least one kind selected from the group consisting of ammonia, potassium hydroxide, sodium hydroxide, tetramethylammonium hydroxide, tetraethylammonium hydroxide, ammonium hydrogen carbonate, ammonium carbonate, potassium hydrogen carbonate, potassium carbonate, sodium hydrogen carbonate, and sodium carbonate. Among others, as more preferable basic compounds, ammonia, potassium hydroxide, sodium hydroxide, tetramethylammonium hydroxide, tetraethylammonium hydroxide, and potassium carbonate are exemplified. When two or more kinds are used in combination, the combination of potassium carbonate and tetramethylammonium hydroxide is preferable, for example.

When the polishing composition is directly used as a polishing slurry, a content of the basic compound is preferably 0.01% by mass or more, more preferably 0.05% by mass or more, and still more preferably 0.07% by mass or more based on the polishing composition. In such a range, high polishing removal rate can be maintained. In addition, stability can also be improved by increasing the content of the basic compound. In addition, when the polishing composition is directly used as a polishing slurry, it is suitable to set an upper limit of the content of the above-described basic compound to 1% by mass or less, and the upper limit is preferably 0.5% by mass or less from the viewpoint of surface quality, etc.

In addition, when the polishing composition is diluted and used for polishing, that is, when the polishing composition is a concentrate, from the viewpoint of storage stability, filtration properties, etc., the content of the basic compound is usually suitable to be 10% by mass or less and is more preferably 5% by mass or less. In addition, from the viewpoint of taking advantage of making the polishing composition into a concentrate, the content of the basic compound is preferably 0.1% by mass or more, more preferably 0.5% by mass or more, and still more preferably 0.9% by mass or more.

When two or more kinds of the basic compound are used in combination, the above-described content refers to a total content of two or more kinds of the basic compound.

[Water]

The polishing composition according to the present invention contains water as a dispersant in order to disperse or dissolve each component. It is preferable that water contain as little impurities as possible from the viewpoint of preventing contamination of a silicon wafer and preventing the actions of other components from being inhibited. Such water is preferably water in which a total content of transition metal ions is 100 ppb or less, for example. Here, the purity of water can be enhanced by an operation such as removal of ion impurities using ion-exchange resin, removal of contaminants by a filter, and distillation, for example. Specifically, it is preferable that deionized water (ion-exchanged water), pure water, ultrapure water, distilled water, or the like be used as water, for example.

An organic solvent may be arbitrarily added, and the organic solvent can be used singly or in combination of two or more kinds. In addition, water and an organic solvent may be used in combination in order to disperse or dissolve each component. In this case, the organic solvent used includes acetone, acetonitrile, ethanol, methanol, isopropanol, glycerin, ethylene glycol, propylene glycol, etc., which are organic solvents miscible with water. In addition, these organic solvents may be used without being mixed with water and then mixed with water after dispersing or dissolving each component.

[Other components]

The polishing composition according to the present invention may further contain publicly known additives which can be used for polishing compositions such as a surfactant, a chelating agent, an antiseptic agent, and an antifungal agent as needed basis within a range not significantly impairing the effect of the present invention.

(Surfactant)

The polishing composition of the present invention may further contain a surfactant such as a nonionic surfactant, a cationic surfactant, and an anionic surfactant if needed.

The nonionic surfactant available for the present invention can be used singly or in combination of two or more kinds. Examples of the nonionic surfactant include an alkyl betaine, an alkyl amine oxide, a polyoxyethylene alkyl ether, a polyoxyalkylene alkyl ether, a sorbitan fatty acid ester, a glycerin fatty acid ester, a polyoxyethylene fatty acid ester, a polyoxyethylene alkyl amine, an alkyl alkanol amide, etc. Among them, from the viewpoint of improving dispersion stability of the polishing composition, a polyoxyalkylene alkyl ether is preferable, and a polyoxyethylene alkyl ether is more preferable.

When the polishing composition is directly used as a polishing slurry, a content of the nonionic surfactant is preferably 0.00001% by mass or more, more preferably 0.00002% by mass or more, and still more preferably 0.00003% by mass or more based on the polishing composition. In such a range, dispersion stability of the polishing composition is improved. When the polishing composition is directly used as a polishing slurry, it is appropriate to set an upper limit of the content of the nonionic surfactant to 0.002% by mass or less, and the upper limit is preferably 0.001% by mass or less from the viewpoint of maintaining high polishing removal rate.

In addition, when the polishing composition is diluted and used for polishing, that is, when the polishing composition is a concentrate, from the viewpoint of storage stability, filtration properties, etc., the content of the nonionic surfactant is usually suitable to be 0.1% by mass or less and is more preferably 0.05% by mass or less. In addition, from the viewpoint of taking advantage of making the polishing composition into a concentrate, the content of the nonionic surfactant is preferably 0.0001% by mass or more, more preferably 0.0002% by mass or more, and still more preferably 0.0005% by mass or more.

When two or more kinds of the nonionic surfactant are used in combination, the above-described content refers to a total content of two or more kinds of the nonionic surfactant.

(Chelating agent)

The chelating agent which may be contained in the polishing composition can be used singly or in combination

of two or more kinds. The chelating agent includes an aminocarboxylic acid-based chelating agent and an organic phosphonic acid-based chelating agent. Examples of the aminocarboxylic acid-based chelating agent include ethylenediaminetetraacetic acid, sodium ethylenediaminetetraacetic acid, nitrilotriacetic acid, sodium nitrilotriacetic acid, ammonium nitrilotriacetic acid, hydroxyethylethylenediaminetriacetic acid, sodium hydroxyethylethylenediaminetriacetic acid, diethylenetriaminepentaacetic acid, sodium diethylenetriaminepentaacetic acid, triethylenetetraminehexaacetic acid, and sodium triethylenetetraminehexaacetic acid. Examples of the organic phosphonic acid-based chelating agent includes 2-aminoethylphosphonic acid, 1-hydroxyethylidene-1,1-diphosphonic acid, aminotri(methylenephosphonic acid), ethylenediaminetetrakis(methylenephosphonic acid) (EDTPO), diethylenetriaminepenta(methylenephosphonic acid), ethane-1,1-diphosphonic acid, ethane-1,1,2-triphosphonic acid, ethane-1-hydroxy-1,1-diphosphonic acid, ethane-1-hydroxy-1,1,2-triphosphonic acid, ethane-1,2-dicarboxy-1,2-diphosphonic acid, methanehydroxyphosphonic acid, 2-phosphonobutane-1,2-dicarboxylic acid, 1-phosphonobutane-2,3,4-tricarboxylic acid, and $\alpha$-methylphosphonosuccinic acid. Among them, organic phosphonic acid-based chelating agents are more preferable. Among others, preferable chelating agents include ethylenediaminetetrakis(methylenephosphonic acid), diethylenetriaminepenta(methylenephosphonic acid), and diethylenetriaminepentaacetic acid. Especially preferable chelating agents include ethylenediaminetetrakis(methylenephosphonic acid) and diethylenetriaminepenta(methylenephosphonic acid).

When the polishing composition is directly used as a polishing slurry, a lower limit of a content of the chelating agent is preferably 0.0001% by mass or more, more preferably 0.001% by mass or more, and still more preferably 0.002% by mass or more based on the polishing composition. An upper limit of the content of the chelating agent is preferably 1% by mass or less, more preferably 0.5% by mass or less, still more preferably 0.3% by mass or less, and especially preferably 0.15% by mass or less.

In addition, when the polishing composition is diluted and used for polishing, that is, when the polishing composition is a concentrate, from the viewpoint of storage stability, filtration properties, etc., the content of the chelating agent is usually suitable to be 5% by mass or less and is more preferably 3% by mass or less and especially preferably 1.5% by mass or less. In addition, from the viewpoint of taking advantage of making the polishing composition into a concentrate, the content of the chelating agent is preferably 0.001% by mass or more, more preferably 0.01% by mass or more, and still more preferably 0.05% by mass or more.

When two or more kinds of the chelating agent are used in combination, the above-described content refers to a total content of two or more kinds of the chelating agent.

The antiseptic agent and antifungal agent which may be contained in the polishing composition can be used singly or in combination of two or more kinds. Examples of the antiseptic agent and antifungal agent include an isothiazolin-based antiseptic agent such as 2-methyl-4-isothiazolin-3-one and 5-chloro-2-methyl-4-isothiazolin-3-one, p-hydroxybenzoate esters, phenoxyethanol, etc., for example.

[Properties of polishing composition]

The polishing composition according to the present invention is supplied to the above-described silicon wafer typically in the form of a polishing slurry including the polishing composition, and used for roughly polishing the silicon wafer. The polishing composition according to the present invention may be diluted and used as a polishing slurry or may be directly used as a polishing slurry, for example. Dilution herein is typically dilution with water. The concept of the polishing composition in the technology according to the present invention encompasses both a polishing slurry (working slurry) to be supplied to a silicon wafer and used for polishing and a concentrate (stock solution of working slurry) to be diluted and used for polishing. A concentration factor of the above-described concentrate can be about two times or more and 140 times or less on volume basis, for example, and is usually suitable to be about 4 times or more and 80 times or less (for example, about 5 times or more and 50 times or less).

When the polishing composition is directly used as a polishing slurry, a pH of the polishing composition is preferably 8.0 or more, more preferably 8.5 or more, still more preferably 9.5 or more, and especially preferably 10.0 or more. Polishing removal rate increases as the pH of the polishing composition increases. On the other hand, when the polishing composition is directly used as a polishing slurry, the pH of the polishing composition is preferably 12.0 or less and more preferably 11.5 or less. When the pH of the polishing composition is 12.0 or less, dissolution of abrasive can be suppressed and mechanical polishing action by the abrasive can be prevented from decreasing.

In addition, when the polishing composition is diluted and used for polishing, that is, when the polishing composition is a concentrate, the pH of the polishing composition is preferably 9.5 or more, more preferably 10.0 or more, and sill more preferably 10.5 or more. In addition, it is appropriate that the pH of the polishing composition is 12.0 or less, and the pH of the polishing composition is preferably 11.5 or less.

The pH of the polishing composition can be measured by using a pH meter. After three-point calibration is performed on a pH meter using standard buffer solutions, a glass electrode is put in the polishing composition. Then, the pH of the polishing composition can be obtained by measuring the value after a lapse of two or more minutes and after the pH is stabilized. For example, a glass electrode-type hydrogen ion concentration indicator (model number: F-23) manufactured by HORIBA, Ltd. can be used as the pH meter. In addition, the standard buffer solutions are, for example, a phthalate pH buffer solution (pH: 4.01), a neutral phosphate pH buffer solution (pH: 6.86), and a carbonate pH buffer solution (pH: 10.01). The pH values herein are values at 25°C.

The polishing composition according to the present invention may be a one-agent type or may be a multi-agent type including a two-agent type. The multi-agent type is a combination of agents in which a part or the whole of the polishing composition is mixed at an arbitrary mixing ratio. In addition, when a polishing device having multiple supplying paths for the polishing composition is used, preliminarily adjusted two or more polishing compositions may be used so that the polishing compositions are mixed on the polishing device.

[Flatness of outer peripheral part of silicon wafer]

An ESFQR is used herein as one index for the flatness of the outer peripheral part of a silicon wafer. The ESFQR (Edge flatness metric, Sector based, Front surface referenced, least squares fit reference plane, Range of the data within sector) is a value obtained by measuring an SFQR within a circular sector area (sector) formed in the outer peripheral part area of the whole circumference of the wafer. An ESFQRmax indicates a maximum value among ESFQRs of all sectors on the wafer, and an ESFQRmean indicates an average value of ESFQRs of all sectors. The ESFQR herein refers to a value of the ESFQRmean. The ESFQR defined herein is a value obtained by measuring the SFQR within a site using ultra-precision surface configuration measuring device "NANOMETRO (R) 300TT" manufactured by Kuroda Precision Industries Ltd., the site has an edge excluded area (Edge Exclusion, a width of the outer peripheral part on the wafer on which no device is formed) being 1 mm, and the site is an area enclosed by the circumference of the wafer divided into 72 at an interval of 5° and the radii constituting the site of which a length is 35 mm . The SFQR (Site Front Least Squares Range) are maximum deviations on the + side (upper side when the wafer is horizontally placed with the surface thereof facing upward) and the - side (lower side) from a reference plane, the reference plane is obtained by calculating data, by a least-square method, within the set site.

In the present embodiment, it is preferable that the difference between the average value of ESFQRs after polishing a silicon wafer and the average value of ESFQRs before polishing a silicon wafer be a negative value, and the larger the absolute value thereof, the better. Flatness of the outer peripheral part of a silicon wafer is better with such a value.

A GBIR (Global Backside Ideal Range) can also be used as another index of flatness of the outer peripheral part of a silicon wafer. The GBIR represents the distance between the maximum height and the minimum height when the whole surface of the back surface of a wafer is adsorbed to a flat chuck face, the back surface is taken as a reference surface, and heights from the above-described reference surface are measured over the whole surface of the wafer.

[Production method for polishing composition]

The polishing composition of the present invention can be obtained by stirring and mixing respective components in water, for example. However, the method is not limited thereto. In addition, a temperature at which respective components are mixed is not particularly limited but is preferably 10°C or higher and 40°C or lower, and heating may be carried out so as to increase rates of dissolution. In addition, mixing time is also not particularly limited.

[Polishing method]

The polishing composition according to the present invention may be used for a silicon wafer polishing step in an aspect including the following operations, for example. Accordingly, the present invention also provides a polishing method for polishing a silicon wafer using the above-described polishing composition.

First, the polishing composition according to the present invention is prepared. Thereafter, the polishing composition is supplied to a silicon wafer, and polishing is performed in a conventional manner. For example, a silicon wafer is set in a general polishing device, and the polishing composition is supplied to a surface (surface to be polished) of the silicon waver through a polishing pad of the polishing device. Typically, the polishing pad is pressed against the surface of the silicon wafer and the two are relatively moved (for example, rotationally moved), while continuously supplying the above-described polishing composition. Polishing of the silicon wafer is completed through such a polishing step.

The polishing pad used for the above-described step is not particularly limited. For example, any of a polyurethane type, a non-woven fabric type, a suede type, one with an abrasive, one without an abrasive, etc. may be used. In addition, as the above-described polishing device, a double side polishing device that simultaneously polishes the both sides of a silicon wafer may be used, or a one side polishing device that polishes only one side of a silicon wafer may be used.

While polishing conditions are also not particularly limited, rotation speed of the platen is preferably 10 rpm

($0.17 s^{-1}$) or more and 500 rpm ($8.3 s^{-1}$) or less, for example, and pressure (polishing pressure) applied to the silicon wafer is 3 kPa or more and 70 kPa or less and is preferably 3.45 kPa or more and 69 kPa or less, for example. A method for supplying the polishing composition to the polishing pad is also not particularly limited, and a continuous supplying method using a pump or the like is adopted, for example. While a supplying amount thereof is not limited, it is preferable that the surface of the polishing pad be always covered with the polishing composition of the present invention.

The above-described polishing composition may be used in a so-called "one-way" or may be circulated and repeatedly used. The term one-way herein refers to an aspect in which the polishing composition once used for polishing is thrown away. A method for using the polishing composition in recycle includes the following example: a method in which a used polishing composition discharged from a polishing device is collected in a tank, and the collected polishing composition is supplied to the polishing device again. When the polishing composition is circulated and used, an environmental burden can be reduced. This is because the amount of the used polishing composition to be disposed as waste liquid is decreased compared with the case where the polishing composition is used in one-way. In addition, costs can be suppressed as the amount used of the polishing composition decreases.

[Application]

As described above, the polishing composition of the present invention is excellent in properties for shaping an outer peripheral part of a silicon wafer. In addition, the polishing composition of the present invention can maintain high polishing removal rate. Utilizing said features, the polishing composition disclosed herein is suitable as a polishing composition for polishing a silicon wafer. It is desirable that improvement in flatness of the outer peripheral part of a silicon wafer is carried out at the initial stage of a polishing step. Therefore, the polishing composition disclosed herein can be preferably used, in particular, in a preliminary polishing step, that is, a first polishing step (primary polishing step) or a subsequent intermediate polishing step (secondary polishing step) in the polishing step. The above-described preliminary polishing step is typically carried out as a double side polishing step in which both sides of a silicon wafer are simultaneously polished. The polishing composition disclosed herein can be preferably used in such a double side polishing step.

Accordingly, the present invention also provides a method for improving flatness of an outer peripheral part of a silicon wafer using a polishing composition containing an abrasive, a basic compound, a phosphorus-containing compound represented by the chemical formula 1, and water. In addition, the present invention provides a flatness-improving agent for an outer peripheral part of a silicon wafer, containing a phosphorus-containing compound represented by the chemical formula 1. Furthermore, the present invention provides a polishing method for polishing a silicon wafer using said flatness-improving agent.

## Examples

The present invention will be described in more detail with reference to the following Examples and Comparative Example. However, the technical scope of the present invention is not limited only to the following Examples.

[Preparation of polishing composition]

(Example 1)

A mixture containing 33% by mass of colloidal silica (average primary particle diameter measured by BET method: 55 nm) as an abrasive, 1.6% by mass of tetramethylammonium hydroxide (TMAH) and 1% by mass of potassium carbonate as basic compounds, and 0.07% by mass of diethyl phosphite as a phosphorus-containing compound was obtained by mixing the above components and ion-exchanged water at room temperature (25°C) to achieve the respective concentrations and stirring the same for 30 minutes. A polishing composition was prepared by adding ion-exchanged water to the obtained mixture to dilute the mixture by a factor of 30 in terms of volume ratio. The pH of the polishing composition according to each example was 10.3.

Contents of respective components in the polishing composition obtained by 30-fold dilution are as follows:

colloidal silica 1.4% by mass
TMAH 0.07% by mass
potassium carbonate 0.04% by mass
diethyl phosphite (manufactured by Tokyo Chemical Industry Co., Ltd., product code "D0521") 0.003% by mass.

(Example 2)

A polishing composition was prepared in the same manner as Example 1 except that diisopropyl phosphite (manufactured by Tokyo Chemical Industry Co., Ltd., product code "P0629") was used as the phosphorus-containing compound instead of diethyl phosphite.

(Example 3)

A polishing composition was prepared in the same manner as Example 1 except that triethyl phosphate (manufactured by Tokyo Chemical Industry Co., Ltd., product code "P0270") was used as the phosphorus-containing compound instead of diethyl phosphite.

(Example 4)

A polishing composition was prepared in the same manner as Example 1 except that a mixture of monoisopropyl phosphate and diisopropyl phosphate (monoisopropyl phosphate: diisopropyl phosphate = 25% to 45%:55% to 75%, manufactured by Tokyo Chemical Industry Co., Ltd., product code "I0227") was used as the phosphorus-containing compound instead of diethyl phosphite.

(Comparative Example 1)

A polishing composition was prepared in the same manner as Example 1 except that no phosphorus-containing compound was used.

(Evaluation on polishing removal rate and surface quality)

[Polishing removal rate]

Silicon wafers were polished using the respective polishing compositions of Examples 1 to 4 and Comparative Example 1 with the following polishing conditions:

<silicon wafer>
work species: <100> plane silicon wafer
work size: 300 mm
<polishing conditions>
polishing machine: 20B-5P-4D (double side polishing machine manufactured by SpeedFam Company Limited)
polishing pad: MH-S15A (manufactured by Nitta Haas Incorporated)
carrier material: SUS aramide-fitted
polishing pressure: 14 kPa
slurry flow rate: 4.5 L/min (use circulation)
polishing removal: 12 μm
gap against carrier: ca. 0 μm
sun gear: 16.2 rpm
internal: 4.5 rpm
upper platen rotating speed: -21.0 rpm
lower platen rotating speed: 35.0 rpm
(clockwise rotation is taken as normal rotation when viewed from above polishing machine)
polishing time: 35 minutes.

[Evaluation on polishing removal rate]

After polishing silicon wafers using the polishing compositions of the respective Examples and Comparative Example, thicknesses of the silicon wafers were measured using ultra-precision surface configuration measuring device "NANOMETRO (R) 300TT" manufactured by Kuroda Precision Industries Ltd., and polishing removal rate was calculated by dividing the difference in thickness before and after polishing by polishing time. The polishing removal rates in Table 1 below show rates when the polishing removal rate obtained by using the polishing composition of Comparative Example 1 is taken as 100%, and a larger numerical value represents higher polishing removal rate.

[ESFQR]

An average value of ESFQRs was measured by using ultra-precision surface configuration measuring device "NANOMETRO (R) 300TT" manufactured by Kuroda Precision Industries Ltd. under the conditions where the site length was 35 mm and the edge excluded area was 1 mm (72 sites in total).

An ESFQR change rate (ΔESFQR) was calculated by the following equation with the average value of ESFQRs before polishing denoted by E0, the average value of ESFQRs after polishing denoted by E1, and polishing time denoted by t.

[Expression 1]

$$\Delta ESFQR\ (nm/min) = (E1 - E0)/t$$

The ESFQR change rates (ΔESFQRs) in Table 1 below show rates when the ΔESFQR obtained by using the polishing composition of Comparative Example 1 is taken as 100%. A larger numerical value represents the fact that flatness of the outer peripheral part of a silicon wafer is better.

Respective evaluation results are shown in Table 1 below.

[Table 1]

**Table 1**

| | Phosphorus-containing compound | ESFQR change rate | Polishing removal rate |
|---|---|---|---|
| Example 1 | Diethyl phosphite | 124% | 93% |
| Example 2 | Diisopropyl phosphite | 112% | 100% |
| Example 3 | Triethyl phosphate | 147% | 98% |
| Example 4 | Mixture of monoisopropyl phosphate and diisopropyl phosphate | 159% | 92% |
| Comparative Example 1 | None | 100% | 100% |

As clear from Table 1 above, it has been found that when the polishing compositions of Examples are used, silicon wafers can be polished at high polishing removal rate, and flatness of the outer peripheral parts of the silicon wafers becomes also good. In addition, it has been found that when the polishing compositions of Example 1 and Example 4 are used, the GBIRs of the silicon wafers also become good.

It has been found that when the polishing composition of Comparative Example 1 is used, flatness of the outer peripheral part of the silicon wafer decreases.

The present application is based on the Japanese patent application No. 2019-179151 filed on September 30, 2019, and the disclosed content thereof is incorporated in its entirety by reference.

## Claims

1. A polishing composition used for polishing a silicon wafer, comprising: an abrasive, a basic compound, a phosphorus-containing compound represented by chemical formula 1 below, and water:

[Formula 1]

(Chemical formula 1)

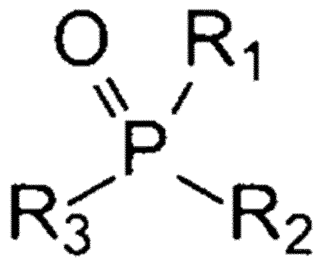

wherein, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

2. The polishing composition according to claim 1, wherein at least one of $R_1$, $R_2$, and $R_3$ in the chemical formula 1 is an unsubstituted straight chain alkoxy group having 1 to 20 carbon atoms.

3. The polishing composition according to claim 1 or 2, wherein the phosphorus-containing compound is a phosphoric acid ester compound.

4. The polishing composition according to any one of claims 1 to 3, which is used in a preliminary polishing step for a silicon wafer.

5. A flatness-improving agent for an outer peripheral part of a silicon wafer, comprising a phosphorus-containing compound represented by chemical formula 1 below:

[Formula 2]

(Chemical formula 1)

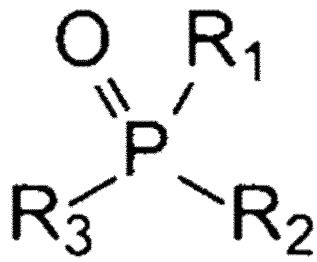

wherein, $R_1$ and $R_2$ are each independently a hydrogen atom, a hydroxy group, or an unsubstituted straight chain or branched alkoxy group having 1 to 20 carbon atoms; and $R_3$ is an unsubstituted straight chain or branched alkoxy group having 1 to 20 carbon atoms.

6. A method for polishing a silicon wafer, comprising performing the polishing using the polishing composition according to any one of claims 1 to 4.

7. A method for polishing a silicon wafer, comprising performing the polishing using the flatness-improving agent

according to claim 5.

**INTERNATIONAL SEARCH REPORT**

International application No.
PCT/JP2020/031090

A. CLASSIFICATION OF SUBJECT MATTER
Int.Cl. C09K3/14(2006.01)i, B24B37/00(2012.01)i, H01L21/304(2006.01)i
FI: H01L21/304622D, B24B37/00H, C09K3/14550Z

According to International Patent Classification (IPC) or to both national classification and IPC

B. FIELDS SEARCHED

Minimum documentation searched (classification system followed by classification symbols)
Int.Cl. C09K3/14, B24B37/00, H01L21/304

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 04-291723 A (ASAHI DENKA KOGYO KK) 15 October 1992 (1992-10-15), claim 1, paragraphs [0001], [0002], [0007]-[0011], [0026], [0027] | 1-7 |
| A | JP 2002-327170 A (KAO CORPORATION) 15 November 2002 (2002-11-15), entire text, all drawings | 1-7 |
| A | JP 2002-047484 A (SANYO CHEMICAL IND LTD.) 12 February 2002 (2002-02-12), entire text, all drawings | 1-7 |
| A | JP 2013-145877 A (JSR CORPORATION) 25 July 2013 (2013-07-25), entire text, all drawings | 1-7 |
| A | JP 2005-167231 A (SHOWA DENKO KK) 23 June 2005 (2005-06-23), entire text, all drawings | 1-7 |

☐ Further documents are listed in the continuation of Box C.  ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 October 2020 | 02 November 2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**
Information on patent family members

International application No.
PCT/JP2020/031090

| | | |
|---|---|---|
| JP 04-291723 A | 15 October 1992 | (Family: none) |
| JP 2002-327170 A | 15 November 2002 | US 2002/0194789 A1<br>entire text, all drawings<br>CN 1384170 A |
| JP 2002-047484 A | 12 February 2002 | (Family: none) |
| JP 2013-145877 A | 25 July 2013 | TW 201331349 A |
| JP 2005-167231 A | 23 June 2005 | US 2007/0082456 A1<br>entire text, all drawings<br>WO 2005/047409 A1<br>EP 1682625 A1<br>CN 1902291 A<br>TW 200521217 A |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016124943 A
- JP 2019179151 A